# EUROPEAN PATENT APPLICATION

(11) **EP 4 564 400 A1**
(43) Date of publication of application: **04.06.2025**
(21) Application number: 23846655.1
(22) Date of filing: 28.07.2023
(51) Int. Cl.: H01L 21/027

(54) **SUBSTRATE PROCESSING METHOD AND SUBSTRATE PROCESSING SYSTEM**

(30) Priority: 29.07.2022 US 202263393638 P
(71) Applicant: Tokyo Electron Limited, Tokyo 107-6325 (JP)
(72) Inventor: NAKANE, Yuta, Kurokawa-gun, Miyagi 981-3629 (JP); KUMAKURA, Sho, Kurokawa-gun, Miyagi 981-3629 (JP)
(74) Representative: FRKelly
(86) International application number: PCT/JP2023/027687
(87) International publication number: WO 2024/024925

(57) **Abstract**

A technique capable of improving a roughness of a surface of a metal-containing resist film formed on a substrate is provided. A substrate processing method includes (a) providing a substrate including an underlying film and a metal-containing resist film in which a pattern is formed on the underlying film; (b) forming a metal-containing film on a surface of the metal-containing resist film; and (c) removing a residue of the metal-containing film together with at least a part of the metal-containing film.

## Description

### Technical Field

An exemplary embodiment of the present disclosure relates to a substrate processing method and a substrate processing system.

### Background Art

Patent Literature 1 discloses a method for forming a thin film to be patterned on a semiconductor substrate using extreme ultraviolet light (EUV).

### Citation List

### Patent Literature

Patent Literature 1: JP2021-523403 A

### Summary of Invention

### Technical Problem

The present disclosure provides a technique capable of improving a roughness of a surface of a metal-containing resist film formed on a substrate.

### Solution to Problem

A substrate processing method in one exemplary embodiment of the present disclosure includes (a) a step of providing a substrate including an underlying film and a metal-containing resist film in which a pattern is formed on the underlying film; (b) a step of forming a metal-containing film on a surface of the metal-containing resist film; and (c) a step of removing a residue of the metal-containing film together with at least a part of the metal-containing film.

### Advantageous Effect of Invention

According to one exemplary embodiment of the present disclosure, it is possible to provide a technique capable of improving a roughness of a surface of a metal-containing resist film formed on a substrate.

### Brief Description of Drawings

[Figure 1] Figure 1 is a diagram for describing a configuration example of a plasma processing system.
[Figure 2] Figure 2 is a diagram for describing a configuration example of a capacitively coupled plasma processing apparatus.
[Figure 3] Figure 3 is a flowchart illustrating an example of a substrate processing method according to one exemplary embodiment.
[Figure 4] Figure 4 is a diagram illustrating an example of a cross-sectional structure of a substrate provided in a step ST1.
[Figure 5] Figure 5 is a descriptive diagram schematically illustrating an example of an X-X cross section of a metal-containing resist film in each of steps ST1, ST2, and ST3.
[Figure 6] Figure 6 is a diagram illustrating an example of a cross-sectional structure of a substrate on which a metal-containing film is formed in the step ST2.
[Figure 7] Figure 7 is a flowchart illustrating an example of the step ST2 using an ALD method.
[Figure 8] Figure 8 is a descriptive diagram schematically illustrating an example of a phenomenon occurring on a surface of the substrate in a step ST21 to a step ST24.
[Figure 9] Figure 9 is a diagram illustrating an example of a cross-sectional structure of a substrate in which a metal-containing film is etched in the step ST3.
[Figure 10] Figure 10 is a flowchart illustrating an example of the step ST3 using an ALE method.
[Figure 11] Figure 11 is a descriptive diagram schematically illustrating an example of a phenomenon occurring on the surface of the substrate in a step ST31 to a step ST34.
[Figure 12] Figure 12 is a flowchart illustrating an example of a substrate processing method in a case of including a step ST5.
[Figure 13] Figure 13 is a diagram illustrating an example of a cross-sectional structure of the substrate in which the underlying film is etched in the step ST5.
[Figure 14] Figure 14 is a side view for describing a configuration example of a semi-batch type plasma processing apparatus.
[Figure 15] Figure 15 is a plan view for describing an example of an internal configuration of the semi-batch type plasma processing apparatus.

### Description of Embodiments

Hereinafter, each embodiment of the present disclosure will be described.

In one exemplary embodiment, there is provided a substrate processing method including (a) providing a substrate including an underlying film and a metal-containing resist film in which a pattern is formed on the underlying film; (b) forming a metal-containing film on a surface of the metal-containing resist film; and (c) removing a residue of the metal-containing film together with at least a part of the metal-containing film.

In one exemplary embodiment, the metal-containing resist film includes at least one metal selected from the group consisting of Sn, Hf, and Ti.

In one exemplary embodiment, the metal-containing resist film contains Sn.

In one exemplary embodiment, the metal-containing resist film is formed by using EUV lithography.

In one exemplary embodiment, in the (b), the metal-containing film is formed by ALD.

In one exemplary embodiment, the (b) includes (b1) supplying a first gas including a metal-containing precursor to the surface of the metal-containing resist film to form a metal-containing precursor film, and (b2) reacting a second gas including an oxidizing gas with the metal-containing precursor film to form the metal-containing film from the metal-containing precursor film.

In one exemplary embodiment, in the (b2), plasma is formed from the second gas.

In one exemplary embodiment, the (b1) and the (b2) are repeated.

In one exemplary embodiment, in the (b), the (b1) is ended before the metal-containing precursor film is formed on an entire surface of the metal-containing resist film, and/or the (b2) is ended before the reaction between the second gas and the metal-containing precursor film is completed.

In one exemplary embodiment, the metal-containing precursor film includes a metal complex.

In one exemplary embodiment, the metal-containing precursor contains the same metal as the metal contained in the metal-containing resist film.

In one exemplary embodiment, the oxidizing gas includes at least one selected from the group consisting of oxygen, ozone, water, hydrogen peroxide, and dinitrogen tetroxide.

In one exemplary embodiment, in the (b), the metal-containing film is formed by CVD.

In one exemplary embodiment, in the (b), the metal-containing film is formed by a mixed gas of a metal-containing gas and an oxidizing gas.

In one exemplary embodiment, in the (b), plasma is formed from the mixed gas to form the metal-containing film.

In one exemplary embodiment, in the (c), the metal-containing film is removed by ALE.

In one exemplary embodiment, the (c) includes (c1) reforming the metal-containing film by using a third gas including a halogen gas, and (c2) removing the reformed metal-containing film by using a fourth gas including a removal precursor.

In one exemplary embodiment, the (c1) and the (c2) are repeated.

In one exemplary embodiment, the halogen gas includes a fluorine-containing gas or a chlorine-containing gas.

In one exemplary embodiment, the removal precursor includes at least one selected from the group consisting of β-diketone and a chlorine compound.

In one exemplary embodiment, the (b) and the (c) are repeated.

In one exemplary embodiment, the (b) and the (c) are executed in the same chamber.

In one exemplary embodiment, the substrate processing method further includes (d) etching the underlying film.

In one exemplary embodiment, the (b), the (c), and the (d) are executed in the same chamber.

In one exemplary embodiment, the underlying film includes at least one selected from the group consisting of a silicon-containing film, a carbon-containing film, and a metal-containing film.

In one exemplary embodiment, there is provided a substrate processing system including:
a substrate processing apparatus having a chamber; and
a controller, in which
the controller is configured to execute
   (a) preparing a substrate including an underlying film and a metal-containing resist film in which a pattern is formed on the underlying film,
   (b) forming a metal-containing film on a surface of the metal-containing resist film, and
   (c) removing a residue of the metal-containing film together with at least a part of the metal-containing film.

Hereinafter, each embodiment of the present disclosure will be described in detail with reference to the drawings. In each drawing, the same or similar elements will be given the same reference numerals, and repeated descriptions will be omitted. Unless otherwise specified, a positional relationship such as up, down, left, and right will be described based on a positional relationship illustrated in the drawings. A dimensional ratio in the drawings does not indicate an actual ratio, and the actual ratio is not limited to the ratio illustrated in the drawings.

### <Configuration Example of Plasma Processing System>

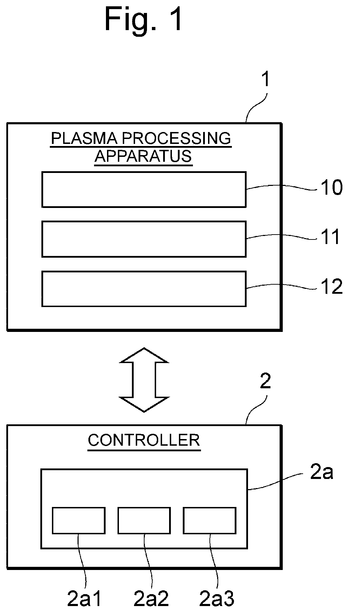

Hereinafter, a configuration example of the plasma processing system will be described. Figure 1 is a diagram for describing a configuration example of the plasma processing system. In an embodiment, the plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber (also simply referred to as a "chamber") 10, a substrate support 11, and a plasma generator 12. The plasma processing chamber 10 has a plasma processing space. In addition, the plasma processing chamber 10 has at least one gas supply port for supplying at least one processing gas to the plasma processing space and at least one gas exhaust port for exhausting the gas from the plasma processing space. The gas supply port is connected to a gas supply 20, described later, and the gas exhaust port is connected to an exhaust system 40, described later. The substrate support 11 is disposed in the plasma processing space and has a substrate support surface for supporting a substrate.

The plasma generator 12 is configured to form a plasma from at least one processing gas supplied into the plasma processing space. The plasma formed in the plasma processing space may be a capacitively coupled plasma (CCP), an inductively coupled plasma (ICP), an electron-cyclotron-resonance (ECR) plasma, a helicon wave plasma (HWP), a surface wave plasma (SWP), or the like. Further, various types of plasma generators including an alternating current (AC) plasma generator and a direct current (DC) plasma generator may be used. In an embodiment, an AC signal (AC power) used in the AC plasma generator has a frequency in the range of 100 kHz to 10 GHz. Therefore, the AC signal includes a radio frequency (RF) signal and a microwave signal. In an embodiment, the RF signal has a frequency in a range of 100 kHz to 150 MHz.

The controller 2 processes a computer-executable instruction that causes the plasma processing apparatus 1 to execute various steps described in the present disclosure. The controller 2 may be configured to control each element of the plasma processing apparatus 1 to execute the various steps described here. In an embodiment, a part or the entirety of the controller 2 may be included in the plasma processing apparatus 1. The controller 2 may include, for example, a computer 2a. The computer 2a may include, for example, a processor (central processing unit (CPU)) 2a1, a storage 2a2, and a communication interface 2a3. The processor 2a1 may be configured to read out a program from the storage 2a2 and execute the read out program to perform various control operations. This program may be stored in the storage 2a2 in advance, or may be acquired through a medium when necessary. The acquired program is stored in the storage 2a2 and is read out from the storage 2a2 and executed by the processor 2a1. The medium may be various storage media readable by the computer 2a, or may be a communication line connected to the communication interface 2a3. The storage 2a2 may include a random access memory (RAM), a read only memory (ROM), a hard disk drive (HDD), a solid state drive (SSD), or a combination thereof. The communication interface 2a3 may communicate with the plasma processing apparatus 1 through a communication line such as a local area network (LAN).

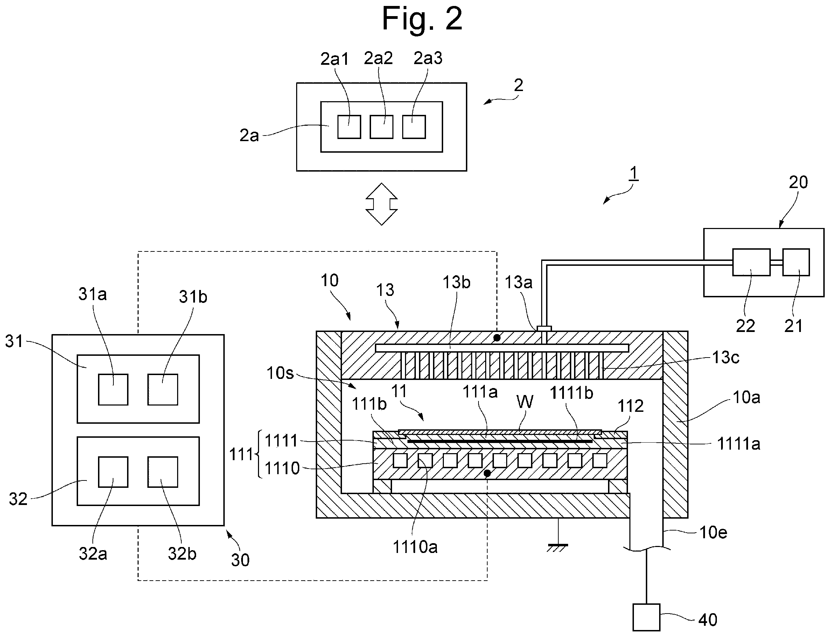

Hereinafter, a configuration example of the capacitively coupled plasma processing apparatus as an example of the plasma processing apparatus 1 will be described. Figure 2 is a diagram for describing the configuration example of the capacitively coupled plasma processing apparatus. The capacitively coupled plasma processing apparatus 1 includes the plasma processing chamber 10, the gas supply 20, a power supply 30, and the exhaust system 40. In addition, the plasma processing apparatus 1 includes the substrate support 11 and a gas introducer. The gas introducer is configured to introduce at least one processing gas into the plasma processing chamber 10. The gas introducer includes a shower head 13. The substrate support 11 is disposed in the plasma processing chamber 10. The shower head 13 is disposed above the substrate support 11. In an embodiment, the shower head 13 configures at least a part of a ceiling of the plasma processing chamber 10. The plasma processing chamber 10 has a plasma processing space 10s defined by the shower head 13, a side wall 10a of the plasma processing chamber 10, and the substrate support 11. The plasma processing chamber 10 is grounded. The shower head 13 and the substrate support 11 are electrically insulated from the housing of the plasma processing chamber 10.

The substrate support 11 includes a main body 111 and a ring assembly 112. The main body 111 has a center region 111a for supporting the substrate W and an annular region 111b for supporting the ring assembly 112. A wafer is an example of the substrate W. The annular region 111b of the main body 111 surrounds the center region 111a of the main body 111 in plan view. The substrate W is disposed on the center region 111a of the main body 111, and the ring assembly 112 is disposed on the annular region 111b of the main body 111 to surround the substrate W on the center region 111a of the main body 111. Therefore, the center region 111a is also referred to as a substrate support surface for supporting the substrate W, and the annular region 111b is also referred to as a ring support surface for supporting the ring assembly 112.

In an embodiment, the main body 111 includes a base 1110 and an electrostatic chuck 1111. The base 1110 includes a conductive member. The conductive member of the base 1110 may function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the center region 111a. In an embodiment, the ceramic member 1111a also has the annular region 111b. Another member that surrounds the electrostatic chuck 1111 may have the annular region 111b, such as an annular electrostatic chuck or an annular insulating member. In this case, the ring assembly 112 may be disposed on the annular electrostatic chuck or the annular insulating member, or may be disposed on both the electrostatic chuck 1111 and the annular insulating member. In addition, an RF or DC electrode may be disposed in the ceramic member 1111a, and in this case, the RF or DC electrode may function as a lower electrode. In a case where a bias RF signal or a DC signal, described later, is connected to the RF or DC electrode, the RF or DC electrode is referred to as a bias electrode. Both of the conductive member of the base 1110 and the RF or DC electrode may function as two lower electrodes.

The ring assembly 112 includes one or a plurality of annular members. In an embodiment, one or the plurality of annular members includes one or a plurality of edge rings and at least one cover ring. The edge ring is formed of a conductive material or an insulating material, and the cover ring is formed of an insulating material.

In addition, the substrate support 11 may include a temperature-controlled module configured to adjust at least one of the electrostatic chuck 1111, the ring assembly 112, and the substrate to a target temperature. The temperature-controlled module may include a heater, a heat transfer medium, a flow passage 1110a, or a combination thereof. A heat transfer fluid such as brine or a gas flows in the flow passage 1110a. In an embodiment, the flow passage 1110a is formed in the base 1110, and one or a plurality of heaters is disposed in the ceramic member 1111a of the electrostatic chuck 1111. Further, the substrate support 11 may include a heat transfer gas supply configured to supply the heat transfer gas to a gap between a back surface of the substrate W and the center region 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes an upper electrode. In addition to the shower head 13, the gas introducer may include one or a plurality of side gas injectors (SGI) attached to one or a plurality of opening portions formed on the side wall 10a.

The gas supply 20 may include at least one gas source 21 and at least one flow rate controller 22. In an embodiment, the gas supply 20 is configured to supply at least one processing gas to the shower head 13 from each corresponding gas source 21 through each corresponding flow rate controller 22. Each flow rate controller 22 may include, for example, a mass flow controller or a pressure-controlled flow rate controller. Further, the gas supply 20 may include at least one flow rate modulation device that modulates or pulses a flow rate of at least one processing gas.

The power supply 30 includes the RF power supply 31 coupled to the plasma processing chamber 10 via at least one impedance matching circuit. The RF power supply 31 is configured to supply at least one RF signal (RF power), such as a source RF signal and a bias RF signal, to at least one lower electrode and/or at least one upper electrode. As a result, plasma is formed from at least one processing gas supplied to the plasma processing space 10s. Therefore, the RF power supply 31 may function as at least a part of the plasma generator 12. Further, by supplying the bias RF signal to at least one lower electrode, a bias potential is generated in the substrate W, and an ion component in the formed plasma is able to be drawn into the substrate W.

In an embodiment, the RF power supply 31 includes a first RF generator 31a and a second RF generator 31b. The first RF generator 31a is coupled to at least one lower electrode and/or at least one upper electrode via at least one impedance matching circuit and is configured to generate a source RF signal (source RF power) for plasma formation. In an embodiment, the source RF signal has a frequency in a range of 10 MHz to 150 MHz. In an embodiment, the first RF generator 31a may be configured to generate a plurality of source RF signals having different frequencies. The generated one or plurality of source RF signals is supplied to at least one lower electrode and/or at least one upper electrode.

The second RF generator 31b is coupled to at least one lower electrode via at least one impedance matching circuit and is configured to generate the bias RF signal (bias RF power). The frequency of the bias RF signal may be the same as or different from the frequency of the source RF signal. In an embodiment, the bias RF signal has a frequency lower than the frequency of the source RF signal. In an embodiment, the bias RF signal has a frequency in a range of 100 kHz to 60 MHz. In an embodiment, the second RF generator 31b may be configured to generate a plurality of bias RF signals having different frequencies. The generated one or plurality of bias RF signals is supplied to at least one lower electrode. In addition, in various embodiments, at least one of the source RF signal and the bias RF signal may be pulsed.

In addition, the power supply 30 may include the DC power supply 32 coupled to the plasma processing chamber 10. The DC power supply 32 includes a first DC generator 32a and a second DC generator 32b. In an embodiment, the first DC generator 32a is connected to at least one lower electrode, and is configured to generate the first DC signal. The generated first DC signal is applied to at least one lower electrode. In an embodiment, the second DC generator 32b is connected to at least one upper electrode and is configured to generate a second DC signal. The generated second DC signal is applied to at least one upper electrode.

In various embodiments, the first and second DC signals may be pulsed. In this case, a sequence of voltage pulses based on DC is applied to at least one lower electrode and/or at least one upper electrode. The voltage pulse may have a pulse waveform having a rectangular shape, a trapezoidal shape, a triangular shape, or a combination thereof. In an embodiment, a waveform generator for generating the sequence of voltage pulses from the DC signal is connected between the first DC generator 32a and at least one lower electrode. Therefore, the first DC generator 32a and the waveform generator configure the voltage pulse generator. When the second DC generator 32b and the waveform generator configure the voltage pulse generator, the voltage pulse generator is connected to at least one upper electrode. The voltage pulse may have a positive polarity or a negative polarity. In addition, the sequence of voltage pulses may include one or a plurality of positive polarity voltage pulses and one or a plurality of negative polarity voltage pulses in one cycle. The first and second DC generators 32a and 32b may be provided in addition to the RF power supply 31, and the first DC generator 32a may be provided instead of the second RF generator 31b.

The exhaust system 40 may be connected to, for example, a gas exhaust port 10e provided at a bottom portion of the plasma processing chamber 10. The exhaust system 40 may include a pressure adjusting valve and a vacuum pump. The pressure in the plasma processing space 10s is adjusted by the pressure adjusting valve. The vacuum pump may include a turbo molecular pump, a dry pump, or a combination thereof.

### <Example of Substrate Processing Method>

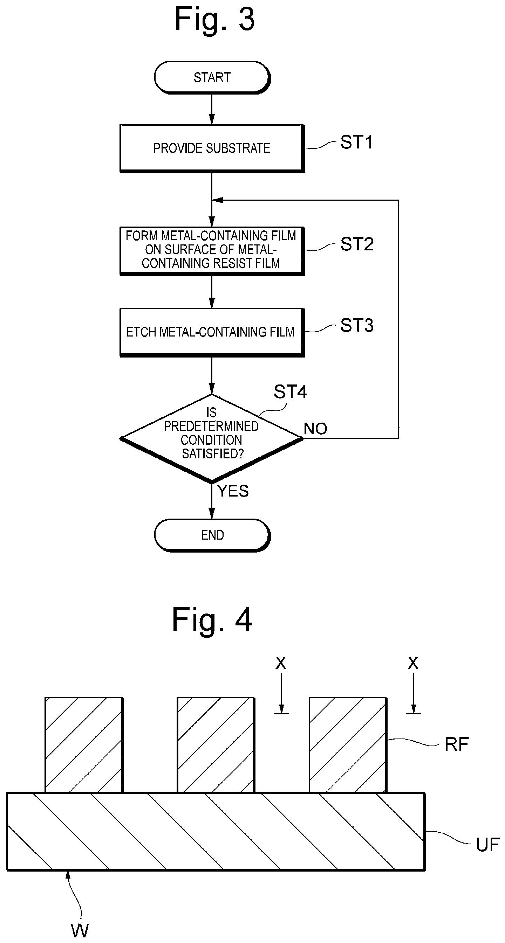

Figure 3 is a flowchart illustrating an example of a substrate processing method (hereinafter, also referred to as "the present processing method") according to one exemplary embodiment. As illustrated in Figure 3, the present processing method includes a step ST1 of providing a substrate including a metal-containing resist film, a step ST2 of forming a metal-containing film on a surface of the metal-containing resist film, and a step ST3 of etching the metal-containing film. The present processing method may include a determination step ST4. The processing in each step may be executed by the plasma processing system illustrated in Figure 1. A case where the controller 2 controls each unit of a plasma processing apparatus 1 to execute the present processing method on a substrate W will be described below as an example.

### (Step ST1: Provision of Substrate)

In an embodiment, in the step ST1, the substrate W is provided in the chamber 10 of the plasma processing apparatus 1. The substrate W is provided on the center region 111a of the substrate support 11. Then, the substrate W is held by the substrate support 11 by the electrostatic chuck 1111.

After the substrate W is disposed in the center region 111a of the substrate support 11, the temperature of the substrate support 11 may be adjusted to a set temperature by the temperature-controlled module. The set temperature may be, for example, a temperature of 300°C or lower, and may be a temperature of 100°C or higher and 300°C or lower (in an example, room temperature). In an example, adjusting or maintaining the temperature of the substrate support 11 includes adjusting or maintaining the temperature of the heat transfer fluid flowing through the flow passage 1110a to the set temperature or a temperature different from the set temperature. In an example, adjusting or maintaining the temperature of the substrate support 11 includes controlling the pressure of the heat transfer gas (for example, He) between the electrostatic chuck 1111 and the back surface of the substrate W. Timing at which the heat transfer fluid starts to flow through the flow passage 1110a may be before or after the substrate W is placed on the substrate support 11, or may be at the same time. In the present processing method, the temperature of the substrate support 11 may be adjusted to the set temperature before the step ST1. That is, the substrate W may be prepared to the substrate support 11 after the temperature of the substrate support 11 is adjusted to the set temperature. In an embodiment, in the subsequent steps of the present processing method, the temperature of the substrate support 11 is maintained at the set temperature adjusted in the step ST1.

Figure 4 is a diagram illustrating an example of a cross-sectional structure of the substrate W provided in the step ST1. As illustrated in Figure 4, in an embodiment, the substrate W has an underlying film UF and a metal-containing resist film RF formed on the underlying film UF. The substrate W may be used for manufacturing a semiconductor device. The semiconductor device includes, for example, a memory device such as a DRAM or a 3D-NAND flash memory, and a logic device.

The underlying film UF may include at least one selected from the group consisting of a silicon-containing film, a carbon-containing film, and a metal-containing film. The underlying film UF is not limited to one layer and may be a plurality of layers. The underlying film UF may be two layers or three layers. The underlying film UF may have a first layer, a second layer, and a third layer from the top to the bottom. The first layer of the underlying film UF may be a spin-on-glass (SOG) film, a SiC film, a SiON film, a Si-containing antireflection film (SiARC), or an organic film. The second layer may be a spin-on carbon (SOC) film, an amorphous carbon film, or a silicon-containing film. The third layer may be a silicon-containing film. The silicon-containing film may be a silicon oxide film, a silicon nitride film, a silicon acid nitride film, a silicon carbon nitride film, a polycrystalline silicon film, or a carbon-containing silicon film. The third layer may be configured by stacking a plurality of types of silicon-containing films. For example, the third layer may be configured by alternately stacking a silicon oxide film and a silicon nitride film. In addition, the third layer may be configured by alternately stacking a silicon oxide film and a polycrystalline silicon film. In addition, the third layer may be a film stack including a silicon nitride film, a silicon oxide film, and a polycrystalline silicon film. In addition, the third layer may be configured by stacking a silicon oxide film and a silicon carbon nitride film. In addition, the third layer may be a film stack including a silicon oxide film, a silicon nitride film, and a silicon carbon nitride film.

The metal-containing resist film RF is a film containing a metal. The metal-containing resist film RF may contain at least one metal selected from the group consisting of Sn, Hf, and Ti. In an example, the metal-containing resist film RF may contain Sn, and may contain tin oxide (SnO) and tin hydroxide (Sn-OH bond). The metal-containing resist film RF may contain an organic substance.

The metal-containing resist film RF is formed in a predetermined pattern having an unevenness (concave portion and convex portion). The metal-containing resist film RF may be formed by a lithography step. The metal-containing resist film RF may be a film (metal-containing EUV resist film) formed by using EUV lithography. In an embodiment, first, a photoresist film containing a metal is formed on the underlying film UF. Next, the photoresist film is selectively irradiated with light (for example, EUV light, or the like) through an exposure mask. As a result, a first region that is exposed and a second region that is not exposed are formed on the photoresist film. Then, the photoresist film is developed, one region (for example, the second region) of the photoresist film is removed, and the metal-containing resist film RF having a pattern with unevenness is formed. The step ST1 may include at least a part of steps (a film forming step, an exposure step, a development step, and the like) of forming the metal-containing resist film RF. At least a part of the step of forming the metal-containing resist film RF may be performed by the plasma processing apparatus 1.

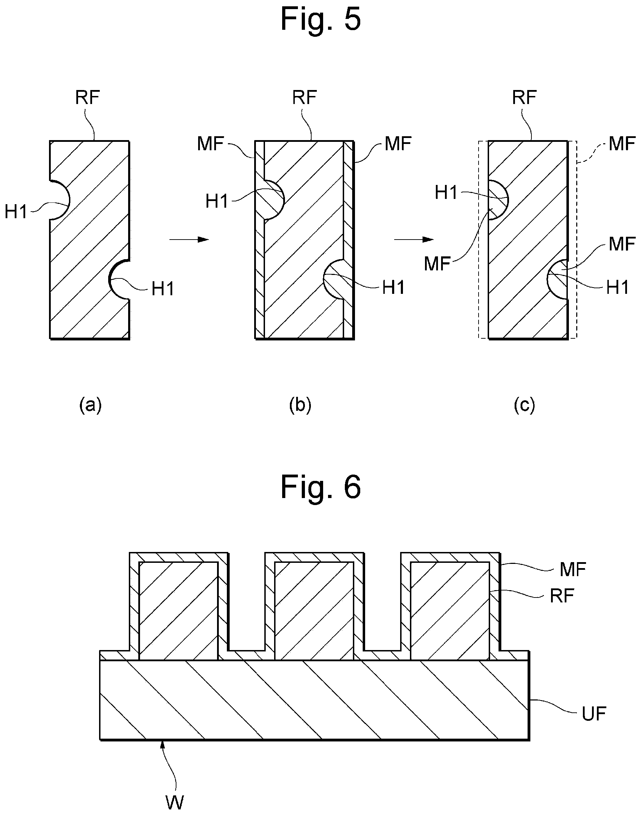

Figure 5 is a descriptive diagram schematically illustrating an example of an X-X cross section of the metal-containing resist film RF in each of the steps ST1, ST2, and ST3 of the present processing method (the cross section taken along the line X-X illustrated in Figure 4). (a) in Figure 5 illustrates an example of a cross section of the metal-containing resist film RF formed in the step ST1. This example illustrates that a concave portion H1 is formed on the side surface of the metal-containing resist film RF. That is, this example illustrates that the surface of the metal-containing resist film RF has roughness. The concave portion H1 is expressed in a simplified and emphasized manner for the sake of description of a recess, and the size and shape thereof are not limited thereto. One of the objects of the present processing method is to improve the roughness of the surface of the metal-containing resist film RF, such as the concave portion H1.

### (Step ST2: Formation of Metal-containing film)

In an embodiment, in the step ST2, the metal-containing film MF is formed on the surface of the metal-containing resist film RF. Figure 6 is a diagram illustrating an example of a cross-sectional structure of the substrate W on which the metal-containing film MF is formed in the step ST2. (b) in Figure 5 illustrates an example of a cross section of the metal-containing film MF formed in the step ST2. In the step ST2, the metal-containing film MF is formed on the surface of the metal-containing resist film RF while filling the concave portion H1 on the side surface of the metal-containing resist film RF. As a result, the surface of the metal-containing resist film RF is flattened, and the roughness is improved. The metal-containing film MF may contain the same metal as the metal contained in the metal-containing resist film RF. The metal-containing film MF may contain a metal different from the metal contained in the metal-containing resist film RF. The metal-containing film MF may contain at least one metal selected from the group consisting of Sn, Hf, and Ti. In an example, the metal-containing film MF may contain Sn.

The formation of the metal-containing film MF in the step ST2 may be carried out by various methods such as an atomic layer deposition (hereinafter, refers to as an ALD method) method, a CVD method, and the like. Hereinafter, various methods of forming the metal-containing film MF will be described.

### (ALD Method)

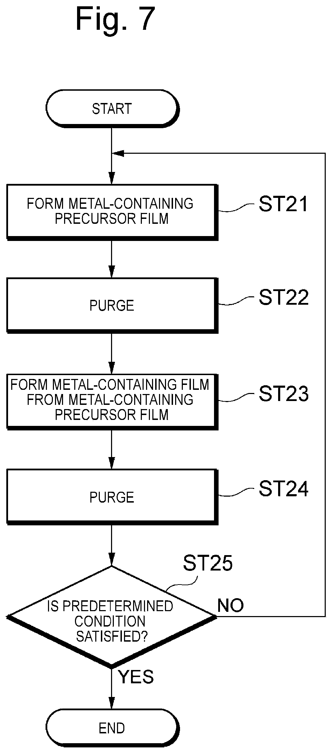

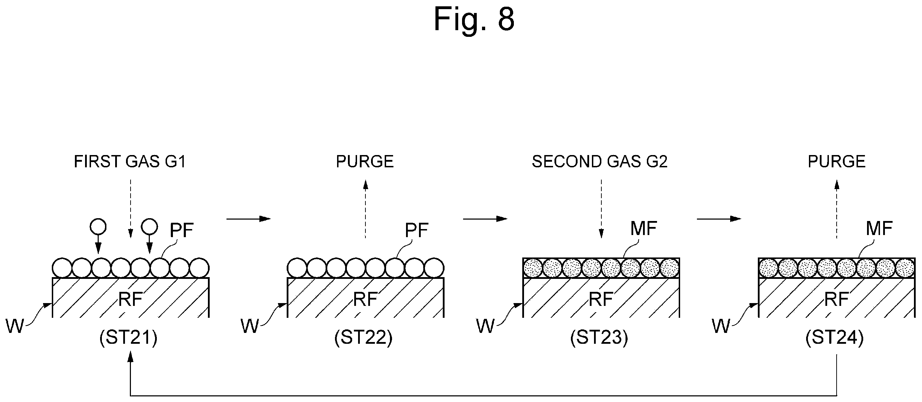

In an embodiment, in the ALD method, a predetermined material is self-controllably adsorbed and reacted with the metal-containing resist film RF formed on the surface of the substrate W to form the metal-containing film MF. As illustrated in Figure 7, in the embodiment, the step ST2 using the ALD method includes a step ST21 of forming a metal-containing precursor film, a first purge step ST22, a step ST23 of forming the metal-containing film MF from the metal-containing precursor film, a second purge step ST24, and a determination step ST25. Figure 8 is a descriptive diagram schematically illustrating an example of a phenomenon occurring on the surface of the substrate W in the step ST21 to the step ST24. The first purge step ST22 and the second purge step ST24 may or may not be performed.

In the step ST21, as illustrated in Figure 8, a first gas G1 containing a metal-containing precursor is supplied to the surface of the metal-containing resist film RF, and a metal-containing precursor film PF is formed. The metal-containing precursor may contain the same metal as the metal contained in the metal-containing resist film RF. The metal-containing resist film RF may contain Sn, and the metal-containing precursor may contain Sn. Examples of the Sn-containing substance may include a stannane compound, an oxygen-containing tin compound, a nitrogen-containing tin compound, a halogenated tin compound, and the like. Examples of the stannane compound may include stannane, tetramethylstannane, tributylstannane, phenyltrimethylstannane, tetravinylstannane, dimethyldichlorostannane, butyltichlorostannane, trichlorophenylstannane, and the like. Examples of the oxygen-containing tin compound may include tributylstannoxides, tert-butoxystannum, dibutyltin diacetate, triphenylstannum acetate, tributylstannoxide, triphenylstannum hydroxide, butylchlorostannum dihydroxide, acetylacetonatosn, and the like. Examples of the nitrogen-containing tin compound may include dimethylaminotrimethylstannyl, tris(dimethylamino)tert-butylstannyl, azidotrimethylstannyl, tetrakis(dimethylamino)stannyl, N,N'-di-tert-butyl-2,3-diamidobutanestannyl (II), and the like. Examples of the halogenated tin compound may include tin chloride, tin bromide, tin iodide, dimethyltin dichloride, butyltin trichloride, phenyltin trichloride, and the like. In addition, the metal-containing precursor may contain Hf, Ti, and the like. In the step ST21 in an embodiment, in the plasma processing apparatus 1, the first gas G1 is supplied from the shower head 13 into the chamber 10. Then, in the chamber 10, the metal-containing precursor of the first gas G1 is adsorbed on the surface of the metal-containing resist film RF, and the metal-containing precursor film PF is formed. The metal-containing precursor film PF may be a metal complex. Examples of the metal complex may include aminotin and the like. The metal-containing precursor film PF may contain the same metal as the metal contained in the metal-containing resist film RF. Examples of the metal contained in the metal-containing precursor film PF may include Hf, Ti, and the like in addition to Sn.

In the step ST21, plasma may be formed from the first gas G1. In this case, in the plasma processing apparatus 1, one or a plurality of RF signals are supplied from the RF power supply 31 to the upper electrode and/or the lower electrode, and plasma is formed in the plasma processing space 10s.

In the step ST22, the gas in the chamber 10 is exhausted by the exhaust system 40. In this case, an inert gas or the like may be supplied to the substrate W. As a result, gases such as an excessive metal-containing precursor are purged.

In the step ST23, as illustrated in Figure 8, the second gas G2 containing an oxidizing gas is supplied to the surface of the metal-containing resist film RF, and the second gas G2 reacts with the metal-containing precursor film PF to form the metal-containing film MF from the metal-containing precursor film PF. The second gas G2 is a gas that reacts with the metal-containing precursor adsorbed on the surface of the metal-containing resist film RF. The oxidizing gas of the second gas G2 may include at least one selected from the group consisting of oxygen, ozone, water, hydrogen peroxide water, and dinitrogen tetroxide. In the step ST23, in the plasma processing apparatus 1, the second gas G2 is supplied from the shower head 13 into the chamber 10. Then, the second gas G2 and the metal-containing precursor film PF react with each other in the chamber 10 to form the metal-containing film MF. In the step ST23, the plasma may be formed from the second gas G2. In this case, in the plasma processing apparatus 1, one or a plurality of RF signals are supplied from the RF power supply 31 to the upper electrode and/or the lower electrode, and plasma is formed in the plasma processing space 10s. In addition, plasma (remote plasma) formed outside the chamber may be introduced into the chamber. In the steps ST21 and ST23, the plasma may not be formed.

In the step ST24, the gas in the chamber 10 is exhausted by the exhaust system 40. In this case, an inert gas or the like may be supplied to the substrate W. As a result, excessive gas such as the second gas G2 is purged.

In the step ST25, it is determined whether a predetermined condition for ending the step ST2 is satisfied. The predetermined condition may be that the processing of the step ST21 to the step ST24 as one cycle is performed a predetermined number of times set in advance. The predetermined number of times may be once, less than 5 times, 5 times or more, or 10 times or more. In a case where it is determined that the predetermined condition is not satisfied in the step ST25, the processing returns to the step ST21, and in a case where it is determined that the predetermined condition is satisfied, the step ST2 ends. For example, the predetermined condition may be a condition related to the dimensions of the metal-containing resist film RF including the metal-containing film MF after the step ST24. That is, after the step ST24, it is determined whether the dimension of the metal-containing resist film RF (the thickness of the metal-containing film MF) has reached a predetermined value or range, and the cycle of the step ST21 to the step ST24 may be repeated until the predetermined value or range is reached. The dimensions of the metal-containing resist film RF may be measured with an optical measuring apparatus.

### (Sub-conformal ALD Method)

In an embodiment, in a sub-conformal ALD method, in the ALD method, the processing conditions are set such that the self-controlled adsorption or reaction does not complete on the surface of the substrate W, and the metal-containing film MF is formed. In an embodiment, in the sub-conformal ALD method, in the above-described ALD method, at least one processing of the following (i) and (ii) is performed.
(i) The step ST21 is ended before the metal-containing precursor film PF is formed on the entire surface of the metal-containing resist film RF, and
(ii) the step ST24 is ended before the reaction between the second gas G2 and the metal-containing precursor film PF is completed.

Other processing in the sub-conformal ALD method may be the same as those in the above-described ALD method. In the sub-conformal ALD method, the plasma may or may not be used in the same manner as in the above-described ALD method.

### (CVD Method)

In an embodiment, in the CVD method, the metal-containing film MF is formed by a mixed gas of the metal-containing gas and the oxidizing gas. As an example, plasma is formed from the mixed gas to form the metal-containing film MF.

In an embodiment, the mixed gas including the metal-containing gas and the oxidizing gas is supplied from the shower head 13 in the plasma processing apparatus 1 into the chamber 10. The metal-containing gas may contain the same metal as the metal contained in the metal-containing resist film RF. The metal-containing resist film RF may contain Sn, and the metal-containing gas may contain Sn. Examples of the Sn-containing substance may include a stannane compound, an oxygen-containing tin compound, a nitrogen-containing tin compound, a halogenated tin compound, and the like. Examples of the stannane compound may include stannane, tetramethylstannane, tributylstannane, phenyltrimethylstannane, tetravinylstannane, dimethyldichlorostannane, butyltichlorostannane, trichlorophenylstannane, and the like. Examples of the oxygen-containing tin compound may include tributylstannoxides, tert-butoxystannum, dibutyltin diacetate, triphenylstannum acetate, tributylstannoxide, triphenylstannum hydroxide, butylchlorostannum dihydroxide, acetylacetonatosn, and the like. Examples of the nitrogen-containing tin compound may include dimethylaminotrimethylstannyl, tris(dimethylamino)tert-butylstannyl, azidotrimethylstannyl, tetrakis(dimethylamino)stannyl, N,N'-di-tert-butyl-2,3-diamidobutanestannyl (II), and the like. Examples of the halogenated tin compound may include tin chloride, tin bromide, tin iodide, dimethyltin dichloride, butyltin trichloride, phenyltin trichloride, and the like. The oxidizing gas may include at least one gas selected from the group consisting of oxygen, ozone, water, hydrogen peroxide water, and dinitrogen tetroxide.

Next, one or the plurality of RF signals are supplied from the RF power supply 31 to the upper electrode and/or the lower electrode. An RF electric field is generated between the shower head 13 and the substrate support 11, and plasma is formed from the mixed gas in the plasma processing space 10s. Then, the metal or the active species containing a metal, which is generated in the plasma, is adsorbed on the surface of the substrate W, and the metal-containing film MF is formed on the surface of the substrate W.

In the CVD method, the metal-containing film MF may be formed using heat (a thermal CVD method) without using plasma.

### (Step ST3: Etching of Metal-containing Film)

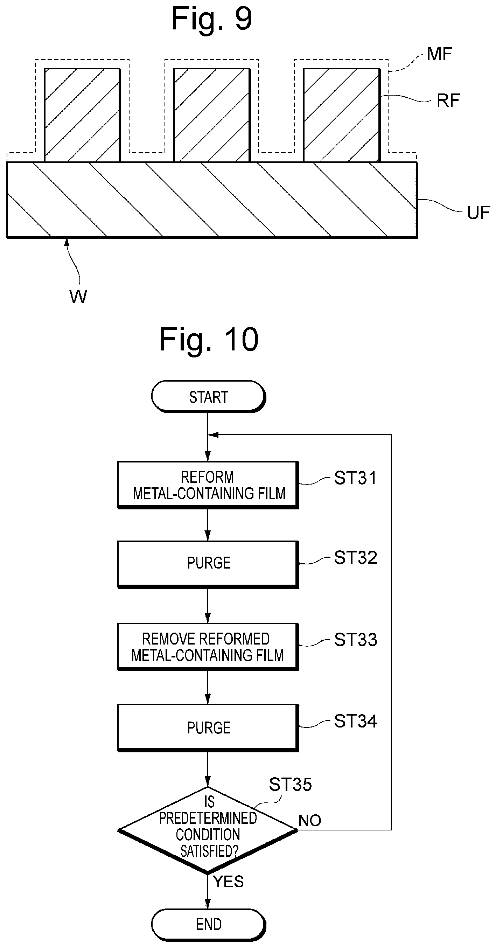

In an embodiment, in the step ST3, the residue of the metal-containing film MF is etched (removed) together with at least a part of the metal-containing film MF formed on the surface of the metal-containing resist film RF. Figure 9 is a diagram illustrating an example of a cross-sectional structure of the substrate W in which the metal-containing film MF is etched in the step ST3. (c) in Figure 5 illustrates an example of the cross section of the metal-containing resist film RF in which the metal-containing film MF is etched in the step ST3. In the step ST3, the metal-containing film MF on the surface of the metal-containing resist film RF is uniformly removed by a predetermined width. In the step ST3, the metal-containing film MF may be removed such that the metal-containing resist film RF is exposed, and in this case, the metal-containing resist film RF is returned to the original dimension before the metal-containing film MF is formed. In addition, the metal-containing film MF may be removed such that the metal-containing resist film RF is not exposed, and in this case, the metal-containing resist film RF is larger than the original dimension before the metal-containing film MF is formed.

The etching of the metal-containing film MF in the step ST3 may be carried out by using various methods such as an atomic layer etching (hereinafter, referred to as ALE) method and a conventional plasma etching method. Hereinafter, a case where the ALE method is used will be described.

### (ALE Method)

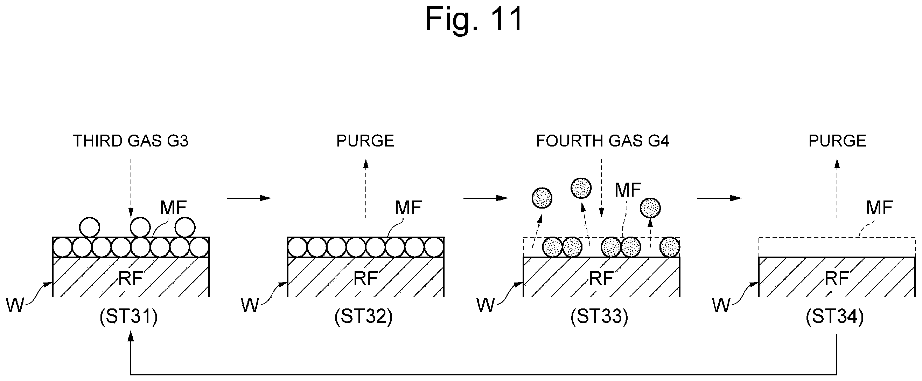

In an embodiment, in the ALE method, the metal-containing film MF is etched by self-controllably adsorbing a predetermined material to the metal-containing film MF formed on the surface of the substrate W, performing a reforming reaction, and removing the reforming portion. As illustrated in Figure 10, in an embodiment, the step ST3 using the ALE method includes a step ST31 of reforming the metal-containing film MF, a first purge step ST32, a step ST33 of removing the reformed metal-containing film MF, a second purge step ST34, and a determination step ST35. Figure 11 is a descriptive diagram schematically illustrating an example of a phenomenon occurring on the surface of the substrate W in the step ST31 to the step ST34. The first purge step ST32 and the second purge step ST34 may or may not be performed.

In the step ST31, as illustrated in Figure 11, a third gas G3 including a halogen gas is supplied to the surface of the metal-containing film MF, and the metal-containing film MF is reformed. The halogen gas may be a fluorine-containing gas or a chlorine-containing gas. The fluorine-containing gas may be a gas containing at least one selected from the group consisting of HF, XeF₂, CF₄, NF₃, and SF₆. Plasma may be formed from HF and XeF₂, or plasma may not be formed. Plasma may be formed from CF₄, NF₃, and SF₆.

In an embodiment, in the step ST31, the third gas G3 is supplied from the shower head 13 to the chamber 10 in the plasma processing apparatus 1. In the step ST31, the halogen gas of the third gas G3 reacts with the metal-containing film MF, and the metal-containing film MF is reformed. In the step ST31, plasma may be formed from the third gas G3. In this case, in the plasma processing apparatus 1, one or a plurality of RF signals are supplied from the RF power supply 31 to the upper electrode and/or the lower electrode, and plasma is formed in the plasma processing space 10s.

In the step ST32, the gas in the chamber 10 is exhausted by the exhaust system 40. In this case, an inert gas or the like may be supplied to the substrate W. As a result, excessive gas such as the third gas G3 is purged.

In the step ST33, as illustrated in Figure 11, a fourth gas G4 including the removal precursor is supplied to the surface of the reformed metal-containing film MF, and the metal-containing film MF is removed. The removal precursor may be a compound that forms a volatile compound by a chemical reaction with molecules on the surface of the reformed metal-containing film MF. The removal precursor of the fourth gas G4 may include at least one selected from the group consisting of β-diketone (acetylacetone, or the like) and a chlorine compound. The removal precursor of the fourth gas G4 may be a chlorine-containing metal precursor. Examples of the chlorine-containing metal precursor may include dimethylaluminum chloride (Al(CH₃)₂Cl: DMAC), SiCl₄, TiCl₄, trichloroaluminum (AlCl₃), trichloroborane (BCl₃), dichlorosilane (SiH₂Cl₂), trichlorosilane (SiHCl₃), chlorodimethylsilane (SiHCl(CH₃)₂), chlorotrimethylsilane (SiCl(CH₃)₃), dichlorodimethylsilane (SiCl₂(CH₃)₂), and trichloromethylsilane (SiCl₃(CH₃)). In the step ST33, in the plasma processing apparatus 1, the fourth gas G4 is supplied from the shower head 13 into the chamber 10. In the step ST33, the fourth gas G4 reacts with the reformed metal-containing film MF to remove the metal-containing film MF. In the step ST33, the plasma may be formed from the fourth gas G4. In this case, in the plasma processing apparatus 1, one or a plurality of RF signals are supplied from the RF power supply 31 to the upper electrode and/or the lower electrode, and plasma is formed in the plasma processing space 10s.

In the step ST34, the gas in the chamber 10 is exhausted by the exhaust system 40. In this case, an inert gas or the like may be supplied to the substrate W. As a result, excessive gas such as the fourth gas G4 is purged.

In the step ST35, it is determined whether a predetermined condition for ending the step ST3 is satisfied. The predetermined condition may be that the processing of the step ST31 to the step ST34 is performed a predetermined number of times set in advance, as one cycle. The predetermined number of times may be once, less than 5 times, 5 times or more, or 10 times or more. In a case where it is determined that the predetermined condition is not satisfied in the step ST35, the processing returns to the step ST31, and in a case where it is determined that the predetermined condition is satisfied, the step ST3 ends. For example, the predetermined condition may be a condition related to the dimensions of the metal-containing resist film RF including the remaining metal-containing film MF after the step ST34. That is, after the step ST34, it is determined whether the dimensions of the metal-containing resist film RF including the remaining metal-containing film MF reach a predetermined value or range, and the cycle of the step ST31 to the step ST34 may be repeated until the predetermined value or range is reached. The dimensions of the metal-containing resist film RF may be measured with an optical measuring apparatus.

The step ST3 may be performed in the same chamber 10 of the plasma processing apparatus 1 as in the step ST2, or may be performed in a chamber 10 of another plasma processing apparatus 1.

In the step ST4, it is determined whether a predetermined condition for ending the present processing method is satisfied. The predetermined condition may be that the processing of the step ST2 and the step ST3 is performed a predetermined number of times set in advance, as one cycle. The predetermined number of times may be once, a plurality of times, twice, 3 times, less than 5 times, 5 times or more, or 10 times or more. In a case where it is determined that the predetermined condition is not satisfied in the step ST4, the processing returns to the step ST2, and in a case where it is determined that the predetermined condition is satisfied, the present processing method ends. For example, the predetermined condition may be a condition related to the dimensions or the surface roughness of the metal-containing resist film RF after the step ST3. That is, after the step ST3, it is determined whether the dimensions and the surface roughness of the metal-containing resist film RF including the remaining metal-containing film MF reach predetermined values or ranges, and the cycles of the step ST2 and the step ST3 may be repeated until the predetermined values or ranges are reached. The dimensions and the surface roughness of the metal-containing resist film RF may be measured with an optical measuring apparatus.

According to the present exemplary embodiment, the present processing method includes (a) the step (ST1) of providing the substrate W including the underlying film UF and the metal-containing resist film RF in which a pattern is formed on the underlying film UF, (b) the step (ST2) of forming the metal-containing film MF on the surface of the metal-containing resist film RF, and (c) the step (ST3) of etching at least a part of the metal-containing film MF. In such a case, the concave portion H1 on the surface of the metal-containing resist film RF is filled with the metal-containing film MF, and then the excess metal-containing film MF is etched. In this manner, the surface of the metal-containing resist film RF formed on the substrate W can be flattened, and the roughness of the surface of the metal-containing resist film RF can be improved.

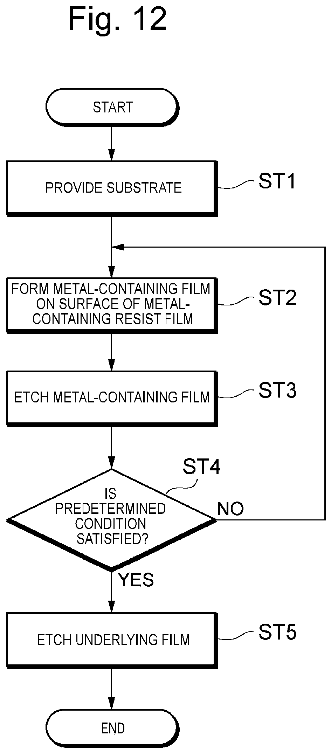

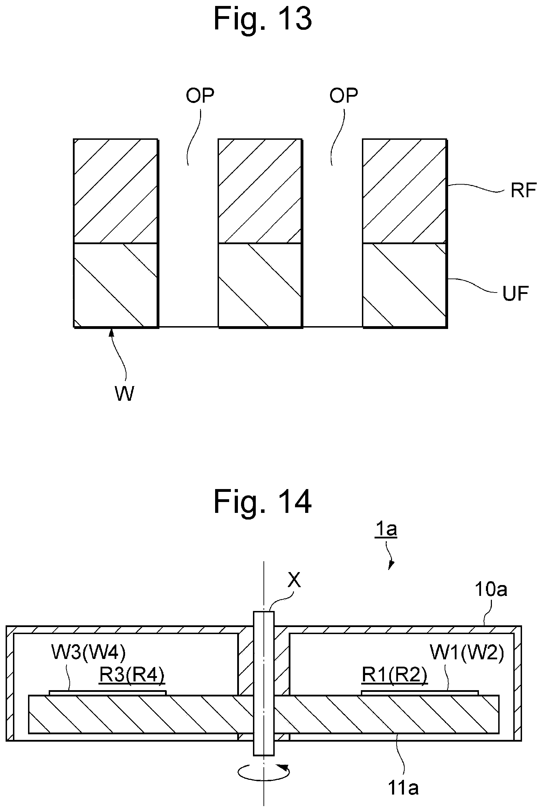

In an embodiment, as illustrated in Figure 12, the present processing method may further include a step ST5 of etching the underlying film UF. In an embodiment, the step ST5 is performed after the step S2, the steps S3, and ST4. Figure 13 is a diagram illustrating an example of a cross-sectional structure of the substrate W in which the underlying film UF is etched in the step ST5.

In an embodiment, in the step ST5, the underlying film UF is etched using the metal-containing resist film RF as a mask. In the step ST5, a portion of the underlying film UF that is not covered with the metal-containing resist film RF (a portion exposed to the opening (concave portion) OP of the metal-containing resist film RF) is etched in a depth direction. The step ST5 may be performed in the chamber 10 of the same plasma processing apparatus 1 as the steps ST2 and ST3. The step ST5 may be performed in the chamber 10 of the plasma processing apparatus 1 different from the step ST2 and the step ST3.

In the step ST5, first, the processing gas is supplied from the shower head 13 into the chamber 10 in the plasma processing apparatus 1. The processing gas includes a gas that generates active species necessary for etching the underlying film UF.

Next, one or the plurality of RF signals are supplied from the RF power supply 31 to the upper electrode and/or the lower electrode. As a result, plasma is formed in the plasma processing space 10s from the processing gas. In addition, the bias signal may be supplied to the lower electrode of the substrate support 11. By supplying the bias RF signal to the lower electrode, a bias potential is generated on the substrate W, and ion components in the formed plasma can be drawn into the substrate W. In this manner, the etching of the underlying film UF may be promoted. A method of etching the underlying film UF is not particularly limited.

The present processing method can also be executed by a semi-batch type plasma processing apparatus in addition to the single-wafer type plasma processing apparatus as illustrated in Figure 2. The semi-batch type plasma processing apparatus may include, for example, a chamber including a plurality of regions arranged in a circumferential direction with respect to a central axis, and a substrate support configured to support a plurality of substrates W, and the substrate support may be configured to rotate such that the substrate W sequentially passes through the plurality of regions.

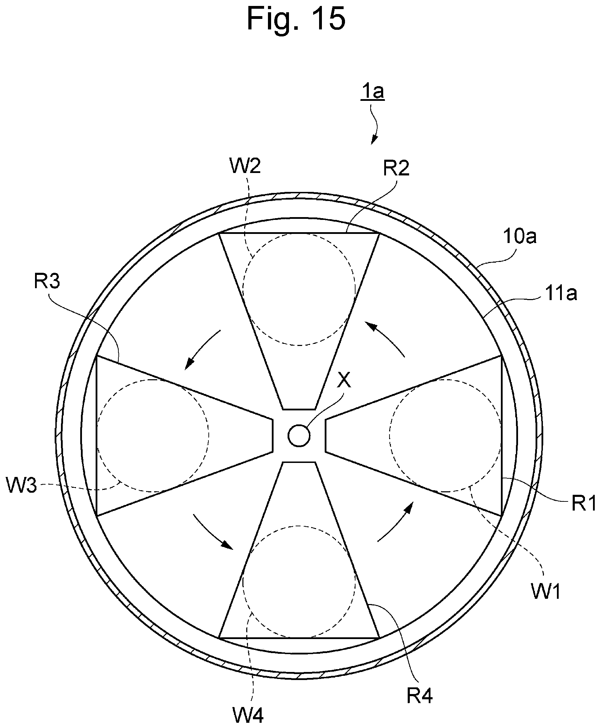

Figure 14 is a side view for describing a configuration example of a semi-batch type plasma processing apparatus 1a. Figure 15 is a plan view for describing an example of an internal configuration of the semi-batch type plasma processing apparatus 1a. In Figures 14 and 15, some configurations such as a gas introducer are not illustrated. As illustrated in Figures 14 and 15, the semi-batch type plasma processing apparatus 1a may be configured to include a chamber 10a including four regions R1 to R4 and a substrate support 11a configured to support t four substrates W1 to W4. The regions R1 to R4 may be configured such that the mixing of the processing gas supplied to each region and the gas exhausted from each region does not occur. In the plasma processing apparatus 1a, the substrate support 11a may be configured to support the four substrates W1 to W4 and to be rotated about a central axis X so that the four substrates W1 to W4 can be sequentially passed from the first region R1 to the fourth region R4. In addition, the plasma processing apparatus 1a may be configured such that the step ST21 and the step ST22 are executed in the first region R1, the step ST23 and the step ST24 are executed in the second region R2, the step ST31 and the step ST32 are executed in the third region R3, and the step ST33 and the step ST34 are executed in the fourth region R4. In the plasma processing apparatus 1a, if the second region R2 in which the step ST23 is executed and the fourth region R4 in which the step ST33 is executed include the plasma generator, the first region R1 and the third region R3 do not necessarily include the plasma generator. According to such the semi-batch type plasma processing apparatus 1a, the time between the respective steps can be shortened, and the throughput of the processing on the substrate W can be significantly improved.

The embodiments of the present disclosure further include the following aspects.

### (Addendum 1)

A substrate processing method including:
(a) providing a substrate including an underlying film and a metal-containing resist film in which a pattern is formed on the underlying film;
(b) forming a metal-containing film on a surface of the metal-containing resist film; and
(c) removing a residue of the metal-containing film together with at least a part of the metal-containing film.

### (Addendum 2)

The substrate processing method according to Addendum 1, in which the metal-containing resist film includes at least one metal selected from the group consisting of Sn, Hf, and Ti.

### (Addendum 3)

The substrate processing method according to Addendum 1, in which the metal-containing resist film contains Sn.

### (Addendum 4)

The substrate processing method according to any one of Addendums 1 to 3, in which the metal-containing resist film is formed by using EUV lithography.

### (Addendum 5)

The substrate processing method according to any one of Addendums 1 to 4, in which in the (b), the metal-containing film is formed by ALD.

### (Addendum 6)

The substrate processing method according to any one of Addendums 1 to 4, in which the (b) includes
(b1) supplying a first gas including a metal-containing precursor to the surface of the metal-containing resist film to form a metal-containing precursor film, and
(b2) reacting a second gas including an oxidizing gas with the metal-containing precursor film to form the metal-containing film from the metal-containing precursor film.

### (Addendum 7)

The substrate processing method according to Addendum 6, in which in the (b2), plasma is formed from the second gas.

### (Addendum 8)

The substrate processing method according to Addendum 6 or 7, in which the (b1) and the (b2) are repeated.

### (Addendum 9)

The substrate processing method according to any one of Addendums 6 to 8, in which in the (b),
the (b1) is ended before the metal-containing precursor film is formed on an entire surface of the metal-containing resist film, and/or
the (b2) is ended before the reaction between the second gas and the metal-containing precursor film is completed.

### (Addendum 10)

The substrate processing method according to any one of Addendums 6 to 9, in which the metal-containing precursor film includes a metal complex.

### (Addendum 11)

The substrate processing method according to any one of Addendums 6 to 10, in which the metal-containing precursor contains the same metal as the metal contained in the metal-containing resist film.

### (Addendum 12)

The substrate processing method according to any one of Addendums 6 to 11, in which the oxidizing gas includes at least one selected from the group consisting of oxygen, ozone, water, hydrogen peroxide, and dinitrogen tetroxide.

### (Addendum 13)

The substrate processing method according to any one of Addendums 1 to 4, in which in the (b), the metal-containing film is formed by CVD.

### (Addendum 14)

The substrate processing method according to any one of Addendums 1 to 4, in which in the (b), the metal-containing film is formed by a mixed gas of a metal-containing gas and an oxidizing gas.

### (Addendum 15)

The substrate processing method according to Addendum 14, in which in the (b), plasma is formed from the mixed gas to form the metal-containing film.

### (Addendum 16)

The substrate processing method according to any one of Addendums 1 to 15, in which in the (c), the metal-containing film is removed by ALE.

### (Addendum 17)

The substrate processing method according to any one of Addendums 1 to 15, in which the (c) includes
(c1) reforming the metal-containing film by using a third gas including a halogen gas, and
(c2) removing the reformed metal-containing film by using a fourth gas including a removal precursor.

### (Addendum 18)

The substrate processing method according to Addendum 17, in which the (c1) and the (c2) are repeated.

### (Addendum 19)

The substrate processing method according to Addendum 17 or 18, in which the halogen gas includes a fluorine-containing gas or a chlorine-containing gas.

### (Addendum 20)

The substrate processing method according to any one of Addendums 17 to 19, in which the removal precursor includes at least one selected from the group consisting of β-diketone and a chlorine compound.

### (Addendum 21)

The substrate processing method according to any one of Addendums 1 to 20, in which the (b) and the (c) are repeated.

### (Addendum 22)

The substrate processing method according to any one of Addendums 1 to 21, in which the (b) and the (c) are executed in the same chamber.

### (Addendum 23)

The substrate processing method according to any one of Addendums 1 to 22, further including (d) etching the underlying film.

### (Addendum 24)

The substrate processing method according to Addendum 23, in which the (b), the (c), and the (d) are executed in the same chamber.

### (Addendum 25)

The substrate processing method according to Addendum 23 or 24, in which the underlying film includes at least one selected from the group consisting of a silicon-containing film, a carbon-containing film, and a metal-containing film.

### (Addendum 26)

A substrate processing system including:
a substrate processing apparatus having a chamber; and
a controller, in which
the controller is configured to execute
   (a) preparing a substrate including an underlying film and a metal-containing resist film in which a pattern is formed on the underlying film,
   (b) forming a metal-containing film on a surface of the metal-containing resist film, and
   (c) removing a residue of the metal-containing film together with at least a part of the metal-containing film.

Each of the above embodiments is described for the purpose of description, and is not intended to limit the scope of the present disclosure. Each of the above embodiments may be modified in various ways without departing from the scope and purpose of the present disclosure. For example, some configuration elements in one embodiment are able to be added to other embodiments. In addition, some configuration elements in one embodiment are able to be replaced with corresponding configuration elements in another embodiment.

### Reference Signs List

- 1: plasma processing apparatus
- 2: controller
- 10: plasma processing chamber
- 10s: plasma processing space
- 11: substrate support
- 13: shower head
- UF: underlying film
- RF: metal-containing resist film
- MF: metal-containing film
- W: substrate

## Claims

1. A substrate processing method comprising:
(a) providing a substrate including an underlying film and a metal-containing resist film in which a pattern is formed on the underlying film;
(b) forming a metal-containing film on a surface of the metal-containing resist film; and
(c) removing a residue of the metal-containing film together with at least a part of the metal-containing film.

2. The substrate processing method according to Claim 1, wherein the metal-containing resist film includes at least one metal selected from the group consisting of Sn, Hf, and Ti.

3. The substrate processing method according to Claim 1, wherein the metal-containing resist film contains Sn.

4. The substrate processing method according to Claim 1, wherein the metal-containing resist film is formed by using EUV lithography.

5. The substrate processing method according to Claim 1, wherein in the (b), the metal-containing film is formed by ALD.

6. The substrate processing method according to Claim 1, wherein the (b) includes
(b1) supplying a first gas including a metal-containing precursor to the surface of the metal-containing resist film to form a metal-containing precursor film, and
(b2) reacting a second gas including an oxidizing gas with the metal-containing precursor film to form the metal-containing film from the metal-containing precursor film.

7. The substrate processing method according to Claim 6, wherein in the (b2), plasma is formed from the second gas.

8. The substrate processing method according to Claim 6, wherein the (b1) and the (b2) are repeated.

9. The substrate processing method according to Claim 6, wherein in the (b),
the (b1) is ended before the metal-containing precursor film is formed on an entire surface of the metal-containing resist film, and/or
the (b2) is ended before the reaction between the second gas and the metal-containing precursor film is completed.

10. The substrate processing method according to Claim 6, wherein the metal-containing precursor film includes a metal complex.

11. The substrate processing method according to Claim 6, wherein the metal-containing precursor contains the same metal as the metal contained in the metal-containing resist film.

12. The substrate processing method according to Claim 6, wherein the oxidizing gas includes at least one selected from the group consisting of oxygen, ozone, water, hydrogen peroxide, and dinitrogen tetroxide.

13. The substrate processing method according to Claim 1, wherein in the (b), the metal-containing film is formed by CVD.

14. The substrate processing method according to Claim 1, wherein in the (b), the metal-containing film is formed by a mixed gas of a metal-containing gas and an oxidizing gas.

15. The substrate processing method according to Claim 14, wherein in the (b), plasma is formed from the mixed gas to form the metal-containing film.

16. The substrate processing method according to Claim 1, wherein in the (c), the metal-containing film is removed by ALE.

17. The substrate processing method according to Claim 1, wherein the (c) includes
(c1) reforming the metal-containing film by using a third gas including a halogen gas, and
(c2) removing the reformed metal-containing film by using a fourth gas including a removal precursor.

18. The substrate processing method according to Claim 17, wherein the (c1) and the (c2) are repeated.

19. The substrate processing method according to Claim 17, wherein the halogen gas includes a fluorine-containing gas or a chlorine-containing gas.

20. The substrate processing method according to Claim 17, wherein the removal precursor includes at least one selected from the group consisting of β-diketone and a chlorine compound.

21. The substrate processing method according to Claim 1, wherein the (b) and the (c) are repeated.

22. The substrate processing method according to Claim 21, wherein the (b) and the (c) are executed in the same chamber.

23. The substrate processing method according to Claim 1, further comprising:
(d) etching the underlying film.

24. The substrate processing method according to Claim 23, wherein the (b), the (c), and the (d) are executed in the same chamber.

25. The substrate processing method according to Claim 23, wherein the underlying film includes at least one selected from the group consisting of a silicon-containing film, a carbon-containing film, and a metal-containing film.

26. A substrate processing system comprising:
a substrate processing apparatus having a chamber; and
a controller, wherein
the controller is configured to execute
(a) preparing a substrate including an underlying film and a metal-containing resist film in which a pattern is formed on the underlying film,
(b) forming a metal-containing film on a surface of the metal-containing resist film, and
(c) removing a residue of the metal-containing film together with at least a part of the metal-containing film.
